# FASCICULE DE BREVET EUROPEEN

(11) **EP 0 377 368 B1**
(45) Date de publication et mention de la délivrance du brevet: **13.03.1996**
(21) Numéro de dépôt: 89403533.6
(22) Date de dépôt: 19.12.1989
(51) Int. Cl.: G11C 16/06

(54) **Dispositif de traitement de données comportant une mémoire non volatile électriquement effaçable et reprogrammable**
Datenverarbeitungsanlage mit einem nichtflüchtigen und elektrisch löschbaren und umprogrammierbaren Speicher
Data-processing device having a non-volatile electrically erasable and reprogrammable memory

(30) Priorité: 20.12.1988 FR 8816788
(43) Date de publication de la demande: 11.07.1990
(73) Titulaire: CP8 TRANSAC, F-78430 Louveciennes (FR)
(72) Inventeur: Ugon, Michel, F-78310 Maurepas (FR)
(74) Mandataire: Corlu, Bernard Edouard

(56) Documents cités:
- EP-A- 0 265 312
- EP-A- 0 270 410
- WO-A-85/03583
- US-A- 4 612 632
- US-A- 4 692 904
- PATENT ABSTRACTS OF JAPAN, vol. 6, no. 38 (P-105)[916], 9 mars 1982;& JP-A-56 156 992
- Modèle d'utilité japonais n 57-152696 (KAWASAKI)

## Description

L'invention est relative à un dispositif de traitement de données comportant au moins une unité de traitement, telle qu'un microprocesseur, et au moins une mémoire non volatile électriquement effaçable et reprogrammable au moins partiellement sous le contrôle de l'unité de traitement.

Dans un dispositif de traitement de données, la mémoire non volatile contient des données qui ne doivent pas être altérées lors de la mise sous tension ou d'une coupure de l'alimentation électrique du dispositif. Ainsi, en particulier, au moins une partie des instructions constituant le programme de fonctionnement du dispositif peut être inscrite dans une mémoire non volatile. En général, la mémoire non volatile qui contient les instructions n'est pas effaçable. Cependant, il existe des mémoires non volatiles qui sont reprogrammables, c'est-à-dire dont le contenu peut être modifié.

Certaines de ces mémoires nécessitent pour leur modification un effacement préalable, par exemple par une exposition à une source de rayonnement ultraviolet. Ce type de mémoire non volatile reprogrammable nécessite une intervention physique du monde extérieur pour la reprogrammation, au moins lors de la phase d'effacement, de sorte qu'il n'est pas possible d'utiliser de telles mémoires dans des systèmes dans lesquels la reprogrammation est totalement contrôlée par l'unité de traitement. Afin de remédier à cet inconvénient, on a conçu des mémoires non volatiles reprogrammables, dans lesquelles l'écriture ou l'effacement s'effectue grâce à l'application de signaux électriques de niveaux compatibles avec les niveaux usuellement rencontrés dans les dispositifs de traitement de données. Ces mémoires sont souvent désignées par l'abréviation EEPROM, qui est contituée par les initiales de leur appelation anglaise (Electrically Erasable Programmable Read Only Memory).

Dans la suite de la présente description, le terme "programmation" doit être pris au sens large, et signifie toutes actions ayant pour conséquence une modification du contenu de la mémoire, c'est-à-dire une écriture ou un effacement du contenu d'une partie au moins de ladite mémoire.

Ainsi, à titre d'exemple, des circuits logiques connus sont alimentés sous une tension de 5 volts, alors que la tension de programmation des mémoires non volatiles électriquement effaçables et reprogrammables est généralement située dans une plage d'environ 12 à 20 volts. En raison de la faible énergie nécessaire à la modification de leur contenu, on a conçu des dispositifs de traitement de données utilisant la même source d'alimentation pour fournir à la fois la tension nécessaire au circuit logique et la tension de programmation des mémoires non volatiles auxquelles ils sont associés. La tension d'alimentation de l'ensemble du dispositif correspond à l'une des deux tensions nécessaires, et un circuit convertisseur est prévu pour obtenir l'autre. Généralement, avec les circuits connus, la source d'alimentation fournit la tension nécessaire au circuit logique, et un convertisseur, tel qu'une pompe à diodes, permet d'obtenir la tension nécessaire à la programmation de la mémoire non volatile.

Il est clair que l'on peut envisager et concevoir des systèmes dans lesquels les tensions d'alimentation des circuits logiques et de programmation de la mémoire non volatile seraient identiques. Dans ce cas, le convertisseur ne serait plus présent.

L'intérêt de mémoires non volatiles effaçables électriquement et reprogrammables est évident, car elles peuvent être programmées directement sur commande de l'unité de traitement, sans intervention de l'extérieur, ce qui autorise par exemple que l'unité de traitement modifie elle-même le programme qui y est contenu, ou inscrive lors d'une utilisation, des données qui seront nécessaires pour une prochaine utilisation, tout en étant susceptibles d'être modifiées au cours de cette prochaine utilisation, ou d'une utilisation ultérieure.

C'est par exemple le cas dans les systèmes de traitement de données utilisant une carte à microcircuits, comportant au moins un microprocesseur et une mémoire non volatile, pour des applications bancaires ou de paiement. Une mémoire non volatile de ce type peut y être incorporée pour conserver la trace des débits et/ou des crédits cumulés, de même qu'un pouvoir d'achat résiduel, qui sont des données susceptibles de changer d'une utilisation à l'autre, mais qu'il est néanmoins nécessaire de conserver, car elles sont importantes pour la mise en oeuvre du système.

Bien entendu, la programmation peut être effectuée sur requête du monde extérieur, l'unité de traitement contrôlant alors dans ce cas la légitimité de la requête et le déroulement des opérations.

Des dispositifs de traitement de données comportant au moins une unité de traitement et une mémoire non volatile effaçable et programmable électriquement peuvent être constitués par un ensemble formé sur un seul substrat, réalisant alors un microprocesseur monolithique, éventuellement autoprogrammable, si le microprocesseur peut lui-même modifier les données inscrites en mémoire non volatile, sans intervention du monde extérieur.

Une telle structure, lorsqu'elle possède une seule source d'alimentation présente néanmoins des inconvénients car il peut arriver que, dans certains cas de fonctionnement transitoire, le contenu de la mémoire non volatile soit modifié accidentellement, alors que l'unité de traitement n'exerce aucun contrôle.

En effet, il peut arriver que la tension de programmation et les signaux de commande soient commutés de façon erratique, alors que tous les circuits logiques du dispositif de traitement ne sont pas stabilisés.

La tension de programmation est une tension nécessaire à la modification de la mémoire non volatile, c'est-à-dire à l'écriture ou à l'effacement, et elle est appliquée lors d'une phase de modification en même temps qu'un signal de commande correspondant, c'est-à-dire un signal de validation d'écriture ou d'effacement.

On connaît, de la demande de modèle d'utilité japonaise n° 57152696, un dispositif selon le préambule de la revendication 1. Ce dispositif vise à résoudre le problème selon lequel des phénomènes de modification incontrôlée de la mémoire non volatile risquent d'intervenir pendant la phase de réinitialisation du dispositif de traitement des données.

La présente invention vise à résoudre de façon plus générale le problème de cette modification incontrôlée de la mémoire non volatile, susceptible d'intervenir, non seulement pendant la phase de réinitialisation, mais aussi lors de la mise sous tension du dispositif ou à tout moment du fonctionnement de celui-ci, en raison notamment de sauts d'adresses erronés qui peuvent intervenir dans l'exécution d'un programme.

Ce problème est résolu par la partie caractérisante de la revendication 1. En effet, au cas où l'une quelconque des causes susceptibles de provoquer une modification incontrôlée de la mémoire non volatile est présente, le risque pour que néanmoins le dispositif soit capable de charger correctement ledit registre selon la configuration de programmation est très faible.

Il va de soi que l'invention est applicable à tout type de dispositif de traitement de données dans lequel l'unité de traitement possède le contrôle plus ou moins partiel de la programmation de la mémoire non volatile, c'est-à-dire qu'elle peut s'appliquer en particulier aux microprocesseurs autoprogrammables, et qu'elle s'applique indifféremment aux microprocesseurs monolithiques ou non.

D'autres caractéristiques et avantages de la présente invention apparaîtront avec la description ci-après faite en regard des figures annexées sur lesquelles :
- la figure 1 est un schéma de principe d'une variante d'un dispositif de traitement de données conforme à l'invention ;
- les figures 2 et 3 illustrent deux variantes des moyens de blocage avec leur environnement ;
- les figures 4 à 7 sont des schémas de principe d'autres variantes du dispositif.

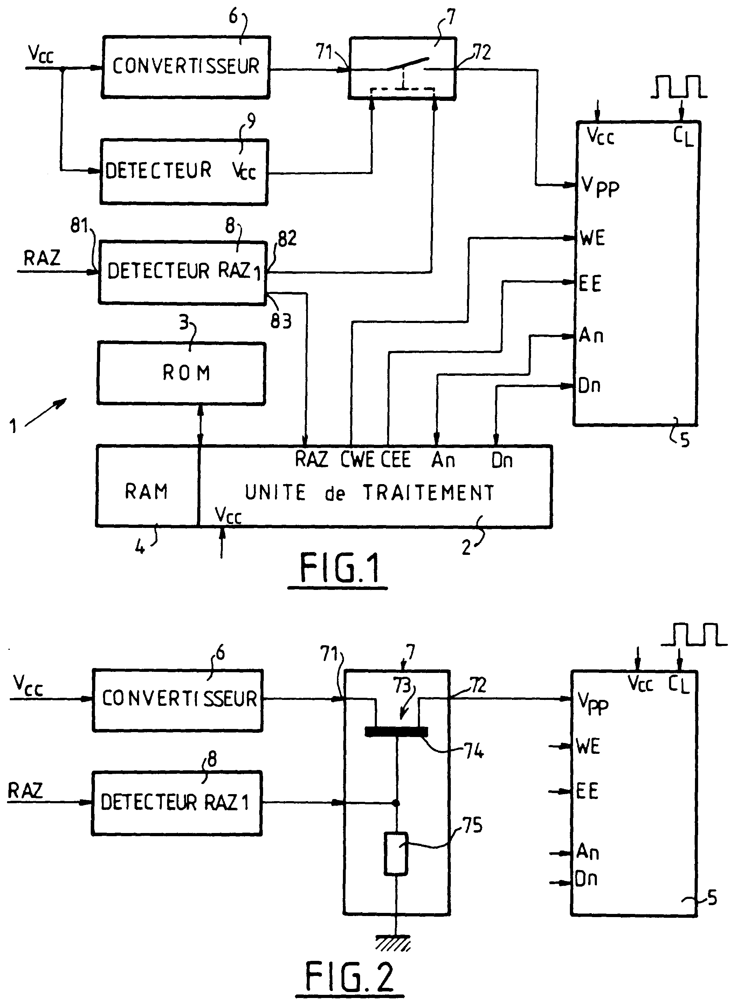

Sur la figure 1 on a illustré schématiquement un premier mode de réalisation d'un dispositif conforme à l'invention.

Le dispositif (1) comporte une unité centrale (2) ou de traitement exécutant un programme enregistré dans une mémoire à lecture seule (3) désignée sous son sigle anglo-saxon ROM, de l'anglais Read Only Memory.

L'unité centrale peut contenir ou être associée à une mémoire à accès aléatoire (4), encore appelée mémoire volatile, et désignée par son sigle RAM, de l'anglais Random Access Memory.

L'unité centrale reçoit la tension d'alimentation V_{cc} du dispositif.

Par ailleurs, conformément à l'invention, le dispositif contient une mémoire non volatile (5) du type électriquement effaçable et programmable. Dans la suite de la description, cette mémoire est appelée la mémoire reprogrammable.

Afin de permettre les opérations d'écriture ou d'effacement, la mémoire reprogrammable (5) comporte une entrée de tension de programmation Vₚₚ, une entrée de signal de validation d'écriture WE et une entrée de signal de validation d'effacement EE, ainsi que des lignes de données Dₙ et d'adresses Aₙ. La gestion des lignes de données et d'adresses est assurée de façon connue par l'unité de traitement (2), et des bus de données et d'adresses, partiellement représentés ici pour ne pas surcharger, sont interconnectés entre l'unité de traitement (2) et les lignes d'adresses et de données de la mémoire. La mémoire reprogrammable (5) comporte également une entrée de signal d'horloge CL. L'horloge peut appartenir au dispositif, ou bien encore appartenir à un dispositif tiers auquel il devrait être connecté.

Dans le cas où la gestion de l'écriture ou de l'effacement est assurée par l'unité de traitement (2), les signaux de validation d'écriture WE ou d'effacement EE proviennent de sorties correspondantes CWE et CEE de l'unité de traitement, et l'application de la tension de programmation Vₚₚ, à l'intérieur de la mémoire non volatile (5), est subordonnée à une requête correspondante issue de l'unité de traitement.

Ainsi, dans les applications bancaires, lorsqu'un tel dispositif est inclu dans une carte à microcircuits, le signal d'horloge est obtenu à partir d'un signal extérieur.

Egalement, la validation de l'écriture ou de l'effacement peut être effectuée différemment selon le type de mémoire utilisée, et il peut arriver que des entrées complémentaires soient nécessaires. Le schéma est ici pour illustrer qu'en général la tension de programmation n'est pas appliquée seule, mais doit être appliquée en combinaison avec un ordre d'écriture ou d'effacement.

Egalement, des circuits internes à la mémoire reprogrammable (5), ou associés à celle-ci, qui n'ont pas été représentés pour ne pas surcharger la figure, et qui sont connus en soi sont prévus pour bloquer la tension de programmation Vₚₚ tant qu'une requête en écriture ou en effacement n'est pas signifiée à la mémoire.

Ces circuits n'entrent pas dans le cadre de la présente invention, mais sont décrits plus en détail par exemple dans le livre de la société Intel déjà cité dans le préambule de la demande. D'une façon générale, ces circuits internes détectent la présence d'une requête sur une entrée WE ou EE de la mémoire non volatile pour gérer en interne le passage de la tension de programmation.

La tension de programmation Vₚₚ peut être obtenue à partir de la tension d'alimentation V_{cc} nécessaire aux circuits logiques du dispositif. Cette tension V_{cc} est appliquée directement à une entrée de l'unité centrale et, dans le cas où elle est différente de la tension Vₚₚ, ce qui arrive dans la majorité des cas, avec les technologies actuelles, un convertisseur (6) est prévu pour obtenir la tension de programmation à partir de la tension d'alimentation. Par exemple, si la tension d'alimentation nominale V_{cc} est de 5 volts, et que la tension de programmation nominale Vₚₚ est de 18 volts, le convertisseur (6) peut être constitué par une pompe à diodes.

Conformément à la présente invention, le dispositif (1) comporte des moyens (7, 8) pour interdire l'application de la tension de programmation Vₚₚ pendant les phases de réinitialisation. A cet effet, dans un mode de réalisation, on prévoit un détecteur (8) qui mesure la valeur de la tension du signal RAZ de demande de réinitialisation du dispositif et qui délivre à sa sortie un signal commandant les moyens de blocage (7) de la tension de programmation, de façon à interdire l'application de ladite tension, tant que la valeur du signal de demande de réinitialisation est telle que ce signal peut être pris en compte pour activer la réinitialisation, c'est-à-dire lorsque ledit signal a atteint un seuil RAZ1 à partir duquel il doit être considéré comme actif.

Ainsi, dans le cas où le signal de réinitialisation est actif à l'état bas, les moyens de détection du signal de demande de réinitialisation détectent le niveau de ce signal et entraînent l'interdiction de l'application d'une tension nécessaire à la programmation lorsque le niveau est inférieur ou égal au seuil. A l'inverse, lorsque ce signal est actif à l'état haut, le blocage de l'application de la tension de programmation est entraîné lorsque le signal de demande de réinitialisation atteint un niveau proche de la valeur de la tension nominale de fonctionnement des circuits logiques du dispositif.

Des circuits connus permettent qu'une demande de réinitialisation soit effectuée automatiquement à la remise sous tension, à l'aide d'un circuit mesurant la tension d'alimentation V_{cc} et délivrant un signal de réinitialisation par exemple dès que la tension minimale de fonctionnement V_{cc} min est atteinte, ou bien lorsque la valeur de la tension d'alimentation est intermédiaire entre la valeur minimale et la valeur nominale.

De préférence, comme l'illustre la figure 1, le détecteur (8) du niveau du signal de réinitialisation entraîne également l'application de l'ordre de réinitialisation à l'unité de traitement (2). A cet effet, l'entrée (81) du détecteur (8) reçoit le signal de réinitialisation émis par exemple à la suite de la mise sous tension du système. Les moyens pour obtenir ce signal de réinitialisation n'ont pas été représentés ici, afin de ne pas surcharger la figure.

Une sortie (82) du détecteur est reliée à une entrée des moyens de blocage (7) de la tension de programmation, et une autre sortie (83) du détecteur est reliée à l'entrée de réinitialisation de l'unité de traitement. Cette structure permet que tant que le signal de réinitialisation apparaissant à l'entrée du détecteur n'est pas de niveau suffisant, et que ce signal est considéré comme non significatif d'une demande de réinitialisation, alors d'une part, la sortie (82) du détecteur (8) reliée à une entrée des moyens de blocage (7) délivre un signal tel que l'application de la tension de programmation peut être autorisée. Comme on le verra plus loin, les moyens de blocage (7) sont également pilotés par un détecteur (9) délivrant un signal interdisant l'application de la tension de programmation si la tension minimale de fonctionnement des circuits logiques du dispositif n'est pas atteinte. Ainsi, en l'absence d'un signal de demande de réinitialisation à l'entrée (81) du détecteur (8), et lorsque la tension minimale de fonctionnement est atteinte, alors les moyens de blocage (7) autorisent l'application de la tension de programmation, et si une requête en programmation de la mémoire reprogrammable a lieu, alors elle peut être prise en compte.

Lorsque la première sortie (82) est dans l'état qui vient d'être mentionné, car le signal le réinitialisation n'est pas suffisant pour être considéré comme actif, alors le détecteur (8) délivre à sa sortie (83) un signal correspondant à une non activation de la réinitialisation de l'unité de traitement (2).

De préférence, le détecteur (8) est un détecteur de seuil sans hystéresis, de façon que, dès lors que la valeur du signal de réinitialisation appliquée à son entrée (81) est telle que ce signal peut être validé, alors ces sorties (82, 83) passent dans un état tel que, d'une part, les moyens de blocage (7) sont activés, et que simultanément un ordre entraînant la réinitialisation de l'unité de traitement est appliqué à l'entrée de cette dernière. A l'inverse, dès que le niveau du signal appliqué à l'entrée (81) du détecteur est tel que ce signal ne doit plus être considéré comme actif, alors les sorties (82, 83) passent dans un état opposé. Par exemple, si la tension nominale de fonctionnement des circuits logiques du dispositif est de 5 volts, alors le niveau apparaissant aux sorties du détecteur passe instantanément de 0 à 5 volts, ou de 5 volts à 0 volt dès que le signal appliqué à l'entrée (81) du détecteur franchit le seuil de basculement.

Enfin, selon que l'on considère que l'état actif du signal de réinitialisation est l'état bas ou l'état haut, le seuil de basculement du détecteur (8) est déterminé différemment. Par exemple, dans le cas où le signal de demande de réinitialisation appliqué à l'entrée (81) doit être considéré comme actif à l'état bas, ce qui signifie que la valeur de ce signal est susceptible de varier entre la valeur nominale de fonctionnement et la valeur zéro, l'apparition d'un signal de réinitialisation se traduit par une transition du signal appliqué à l'entrée (81) du détecteur (8), entre la valeur nominale et la valeur zéro. A l'inverse, lorsque le signal de demande de réinitialisation disparaît, après que la remise à zéro des registres du dispositif ait été effectuée, alors le signal appliqué à l'entrée du détecteur passe de la valeur zéro à la valeur nominale. En d'autres termes, dans un tel cas, un signal de demande de réinitialisation qui apparaît se traduit par un front descendant du signal appliqué à l'entrée du détecteur (8), et la disparition du signal de demande de réinitialisation se traduit par l'apparition d'un front montant à la même entrée. C'est pourquoi, de préférence, il suffit de concevoir ou de choisir le détecteur de seuil, de façon que le seuil de basculement soit compris entre la valeur nominale d'alimentation et la valeur nulle. Par exemple, si la tension nominale de fonctionnement des circuits est de 5 volts, et dans le cas où le signal de réinitialisation est actif à l'état bas, on choisira le détecteur de seuil de façon que le basculement survienne lorsque le signal appliqué à l'entrée (81) du détecteur de l'ordre de 4 volts, et dans le cas où le signal de réinitialisation est actif à l'état haut, le seuil de basculement sera par exemple de 2 volts. Bien entendu, ces valeurs ne sont pas limitatives, mais elles montrent qu'il est préférable que la valeur de basculement soit proche de la valeur pour laquelle le signal de réinitialisation n'est pas actif, mais pour qu'un changement d'état de ce signal, entre son état non actif et son état actif, soit pris en compte très rapidement, afin de ne pas perdre de temps pour la réinitialisation. Ceci permet d'appliquer très rapidement l'ordre effectif de réinitialisation à l'unité de traitement d'une part, et un signal entraînant le blocage de l'application de la tension de programmation par les moyens (7) de blocage, d'autre part.

Ainsi, on constate que, si un ordre de validation d'écriture est appliqué sur l'entrée de validation d'écriture WE de la mémoire reprogrammable (5), ou si un ordre de validation d'effacement est appliqué sur l'entrée de validation d'effacement EE de ladite mémoire, tant que la réinitialisation a lieu, alors l'application de l'un ou l'autre de ces ordres est inopérante puisque la tension de programmation Vₚₚ est bloquée.

De préférence, comme illustré par cette figure, les moyens de blocage (7) sont interposés entre la sortie du convertisseur (6) lorsqu'il est présent et l'entrée de la tension de programmation Vₚₚ de la mémoire non volatile.

En fait, l'ensemble constitué par les moyens de blocage (7) et le circuit détecteur de seuil (8), pour détecter le seuil de blocage RAZ1, constitue un interrupteur électronique à seuil, autorisant que la tension de sortie du convertisseur (6) soit appliquée à l'entrée de la mémoire reprogrammable (5) lorsque le signal de demande de réinitialisation RAZ atteint une valeur suffisante RAZ1 à laquelle il peut être pris en compte pour entraîner la réinitialisation des circuits logiques du dispositif.

Les ordres de validation d'écriture WE ou d'effacement EE sont issus de l'unité centrale (2). Or, tant que les circuits logiques de l'unité centrale (2) ne sont pas stabilisés, un signal de validation d'écriture ou d'effacement peut être transmis accidentellement à la mémoire non volatile. En conséquence, dans une variante non représentée, on prévoit des circuits de blocage de ces signaux, pilotés également par le détecteur (8) de seuil, pour interdire la transmission d'un tel signal qui serait issu de l'unité centrale (2) tant que le signal de réinitialisation n'a pas une valeur suffisante. Cependant, en tout état de cause, il est nécessaire de conserver des moyens de blocage (7) de la tension de programmation Vₚₚ, car il peut arriver que des signaux transitoires propres aux circuits électroniques internes de la mémoire reprogrammable (5) soient générés à l'intérieur de cette dernière, notamment au niveau des circuits de validation d'écriture ou d'effacement qui pourraient entraîner de façon incontrôlée, notamment lors des mises sous tension, l'effacement ou l'écriture de données dans la mémoire reprogrammable.

C'est pourquoi, de préférence, si des circuits de blocage de l'application des tensions de validation d'écriture ou d'effacement sont présents, les moyens (7) de blocage de l'application de la tension de programmation demeurent présents.

Sur la figure 1, on a également illustré la présence d'un circuit (9) dont l'entrée reçoit la tension d'alimentation V_{cc} du dispositif et dont la sortie est reliée aux moyens (7) de blocage de la tension de programmation. Ce circuit (9) est un détecteur de seuil dont la fonction est d'interdire l'application de la tension de programmation chaque fois que la tension d'alimentation V_{cc} est inférieure à une valeur donnée qui est la valeur minimale pour laquelle les circuits logiques du dispositif fonctionnent correctement. Ce circuit est connu en soi, et il en a été fait mention dans le préambule de la présente demande. Il permet, en complément des circuits spécifiques à la présente invention, qui sont actifs pendant les phases de réinitialisation du système, d'interdire l'application de la tension de programmation lors des mises sous tension ou hors tension du dispositif, ou lors d'une baisse de tension accidentelle.

L'action de ce détecteur (9) associé aux moyens (7) de blocage est complémentaire de l'action du détecteur (8) du niveau RAZ1 du signal de réinitialisation associé aux dits moyens de blocage (7) de l'application de la tension de programmation, de sorte que la tension de programmation Vₚₚ ne peut pas être appliquée sur la borne d'entrée correspondante de la mémoire reprogrammable (5) lorsque soit le niveau de la tension d'alimentation V_{cc}, soit le niveau du signal de demande de réinitialisation n'est pas compatible.

La figure 2 illustre un principe de constitution des moyens de blocage (7) lorsque seule la valeur du signal de réinitialisation est prise en compte pour déterminer l'autorisation ou l'interdiction de l'application de la tension de programmation à la mémoire reprogrammable (5). Les moyens de blocage (7) sont par exemple constitués par un montage à transistor (73) fonctionnant en tout ou rien, qui laisse passer la tension de programmation Vₚₚ lorsque le signal de demande de réinitialisation n'est plus actif. A cet effet, le circuit interne des moyens de blocage (7) est monté de façon telle que l'électrode de commande (74) du montage à transistor (73) reçoive le signal du circuit (8) détecteur de la valeur du signal de demande de réinitialisation. L'entrée (71) des moyens de blocage est reliée à la sortie du convertisseur (6) ou, de façon générale, au circuit délivrant la tension de programmation, s'il est indépendant du circuit d'alimentation des circuits logiques, et la sortie (72) des moyens de blocage (7) est reliée à l'entrée de la tension de programmation Vₚₚ de la mémoire reprogrammable (5). Par exemple, le signal appliqué sur l'entrée (71) des moyens de blocage (7) est transmis au drain du montage à transistor MOS, alors que la sortie (72) est reliée à la source du même montage. Dans ce cas, une résistance (75) est placée entre l'électrode de commande, c'est-à-dire la grille, et la masse.

De préférence, le circuit détecteur (8) est un détecteur de seuil sans hystéresis. Ce circuit est choisi de façon à émettre à sa sortie un signal rendant le montage à transistor (73) conducteur lorsque le signal de réinitialisation n'est plus actif.

Il en résulte que, tant que le signal de demande de réinitialisation est actif, l'application de la tension de programmation Vₚₚ est interdite par le circuit de blocage (7).

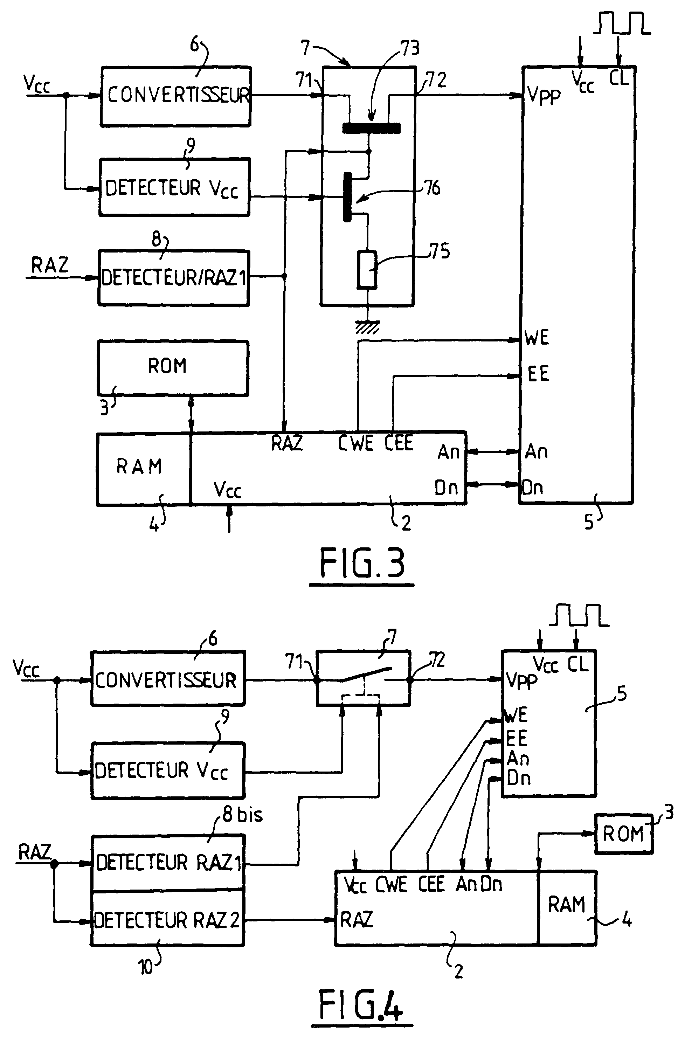

La figure 3 illustre le cas où non seulement le signal de demande de réinitialisation est pris en compte pour bloquer l'application de la tension de programmation Vₚₚ sur la mémoire reprogrammable (5), mais encore le cas où on tient compte également du niveau de la tension d'alimentation des circuits logiques du dispositif. Les moyens de commande (7) sont agencés dans ce cas pour prendre en compte le signal issu du détecteur (8) du niveau du signal de demande de réinitialisation et/ou le signal du détecteur (9) du niveau de la tension d'alimentation. Le détecteur (9) est également un détecteur à seuil, qui délivre à sa sortie un signal de commande des moyens (7) de blocage, autorisant la programmation, si une requête à cet effet a lieu, lorsque la tension d'alimentation est comprise entre la valeur minimale V_{ccmin} pour laquelle les circuits logiques commencent à fonctionner correctement et la tension nominale V_{ccnom} d'alimentation. Ainsi, dans le cas de circuits alimentés sous une tension nominale de 5 volts, le détecteur (9) délivre un signal autorisant l'application de la tension de programmation dès que la tension est par exemple de 4 volts, dans le cas où les circuits logiques fonctionnent correctement à partir de 3 volts.

Les moyens de commande (7) sont, dans ce cas, agencés par exemple de la façon suivante : ils comprennent le premier transistor (73) déjà mentionné qui reçoit sur l'une de ses électrodes le signal issu du convertisseur (6), et dont une autre électrode est reliée par l'intermédiaire de la sortie (72) des moyens de blocage (7) à l'entrée Vₚₚ de la mémoire reprogrammable (5) ; l'électrode de commande (74) du dit transistor reçoit le signal issu du détecteur (8) de mesure du niveau du signal de demande de réinitialisation, et un second transistor (76), dont l'électrode de commande (77) est reliée à la sortie du détecteur (9) de la tension d'alimentation, est intercalé entre la résistance (75) et le point commun à la sortie du détecteur (8) et à l'électrode de commande (74) du premier transistor (73), de sorte qu'une seconde électrode de ce second transistor (76) est reliée au dit point commun, et que sa troisième électrode est reliée à la résistance (75).

Dans ce cas, le premier transistor (73) conduit lorsqu'un signal est appliqué sur son électrode de commande (74), par l'intermédiaire du détecteur de signal de demande de réinitialisation (8) et que simultanément le second transistor (76) est non conducteur. Pour que ce second transistor (76) soit conducteur, afin de bloquer la programmation, il faut qu'un signal soit appliqué sur son électrode de commande (77), ce qui est le cas lorsque le détecteur (9) détecte que la tension d'alimentation est inférieure à la valeur minimun de fonctionnement correct des circuits logiques du dispositif.

Bien entendu, tout autre type de montage est possible, les figures qui viennent être décrites n'étant qu'une illustration du principe de fonctionnement du dispositif. Ce qui est primordial est que les moyens de blocage (7) de la tension de programmation constituent un interrupteur commandé qui autorise l'application de ladite tension de programmation Vₚₚ uniquement lorsque la valeur d'alimentation est correcte et lorsque le signal de réinitialisation n'est pas actif.

Par ailleurs, on constate sur cette figure que le détecteur (8) comporte une seule sortie reliée à la fois à l'électrode de commande des moyens de blocage et à l'entrée de réinitialisation de l'unité de traitement (2). Ceci est envisageable dans les cas où la technologie utilisée permet que le même niveau de signal soit utilisé pour la commande et pour la réinitialisation.

Le circuit qui vient d'être illustré présente cependant l'inconvénient que l'application de la tension de programmation est autorisée dès que l'ordre de réinitialisation disparaît. En raison des temps de réponse des divers circuits, il peut arriver que l'ordre de déblocage de l'application de la tension de programmation soit pris en compte avant que l'ordre de réinitialisation ait disparu, et qu'un transitoire survienne simultanément dans les circuits de traitement, qui valide un ordre d'effacement ou d'écriture de façon incontrolée, de sorte que des informations erratiques peuvent éventuellement être inscrites dans la mémoire reprogrammable.

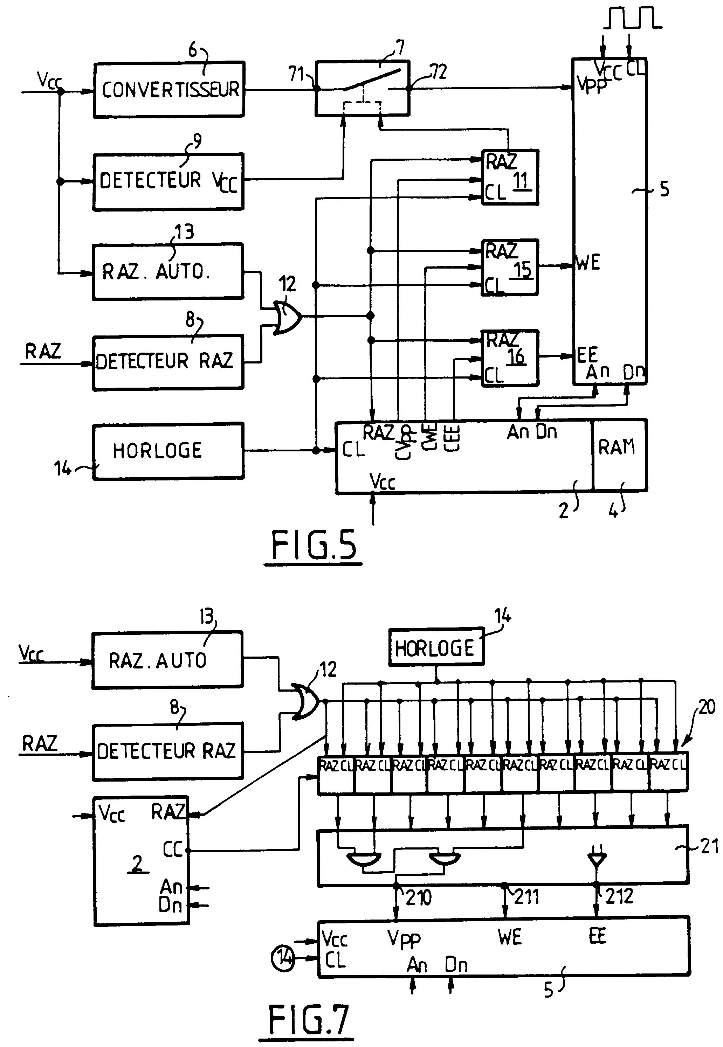

C'est pourquoi, dans une variante, dont le principe est illustré par la figure 4, on prévoit deux circuits de détection du niveau du signal de demande de réinitialisation des circuits, un premier circuit de détection (8 bis) dont la sortie est reliée aux moyens (7) de blocage de la tension de programmation, et un second circuit de détection (10) dont la sortie est reliée à l'entrée de réinitialisation de l'unité de traitement (2). Les deux circuits de détection (8 bis, 10) possèdent des seuils (RAZ1, RAZ2) de détection différents, de sorte que lorsqu'un signal de demande de réinitialisation RAZ apparaît à l'entrée de ces circuits, le premier circuit (8) délivre un signal de blocage des moyens (7) avant que le second circuit (10) ait activé le signal de réinitialisation de l'unité de traitement (2), afin de permettre que, lorsqu'un signal de demande de réinitialisation apparaît, le blocage de l'application de la tension de programmation soit effectif avant que l'ordre de réinitialisation soit appliqué à l'unité de traitement (2), et que lorsque le signal de demande de réinitialisation appliqué à l'entrée des circuits de détection (8 bis, 10) passe d'un état actif à un état non actif, le déblocage soit effectif après que l'ordre de réinitialisation appliqué à l'entrée correspondante de l'unité de traitement (2) ait disparu. On a donc un séquencement temporel entre l'application des différents signaux de commande qui accroît la sécurité de fonctionnement du dispositif.

Ainsi, dans tous les cas, le blocage précède la phase de réinitialisation et le déblocage suit la fin de la phase de réinitialisation.

Le circuit de la figure 4 est donc très performant puisqu'il permet que l'ordre de réinitialisation des circuits du dispositif disparaisse avant que l'autorisation d'une application de la tension de programmation survienne. Par ailleurs, ce circuit comporte les moyens de blocage de la tension de programmation lorsque la tension minimum d'alimentation n'est pas atteinte, de sorte qu'à la mise sous tension, l'autorisation de l'application de la tension de programmation ne peut avoir lieu qu'après que la tension minimum de fonctionnement ait été atteinte d'une part, et que d'autre part lorsque le signal de réinitialisation n'est pas actif. En cas d'un retrait accidentel ou volontaire de la tension d'alimentation, la présence du circuit (9) de détection de la tension d'alimentation entraîne un blocage de l'autorisation de l'application de la tension de programmation Vₚₚ dès que la tension d'alimentation devient inférieure ou égale à la tension minimum de fonctionnement correct.

Il peut cependant arriver que les dispositifs réalisés selon les variantes précédemment décrites ne réduisent pas totalement les risques d'effacement ou d'écriture accidentels dans la mémoire reprogrammable (5) lors de la réinitialisation.

En effet, selon la variante réalisée, soit l'autorisation de l'application de la tension de programmation est donnée en même temps que l'ordre de réinitialisation disparaît, soit ladite autorisation est retardée par rapport à la disparition de l'ordre de réinitialisation, mais ce retard dépend uniquement de la vitesse de transition du niveau de la tension du signal de réinitialisation, qui peut être très rapide.

Or, généralement la réinitialisation s'effectue selon un séquencement programmé, piloté par l'horloge du dispositif, de sorte que la réinitialisation peut, dans certains cas exceptionnels, se prolonger après que le signal lui-même ait disparu.

Or, les dispositifs décrits en regard des variantes précédentes sont tels que lorsque le signal de demande de réinitialisation n'est plus actif, une autorisation de l'application de la tension de programmation est donnée. Il peut donc arriver, dans ce cas, qu'une écriture ou un effacement soit fait accidentellement alors que la réinitialisation n'est pas totalement terminée à partir du moment où l'autorisation de l'application de la tension de programmation est accordée, si un ordre correspondant apparaît.

La variante illustrée par la figure 5 permet d'éviter une programmation accidentelle lorsque le signal de demande de réinitialisation n'est plus actif alors que la réinitialisation n'est pas terminée.

Le dispositif de l'invention comporte au moins un registre (11) dont la sortie est reliée aux moyens de blocage (7) de la tension de programmation Vₚₚ de la mémoire reprogrammable (5), et dont l'entrée de réinitialisation est connectée par l'intermédiaire d'un circuit combinatoire (12) d'une part à la sortie d'un circuit (13) de réinitialisation automatique à la mise sous tension, et d'autre part à la ligne de demande de réinitialisation du système en cours de fonctionnement de préférence par l'intermédiaire d'un détecteur (8) du niveau du signal de demande de réinitialisation, pour que ledit signal soit pris en compte à partir d'un seuil déterminé. L'entrée de données du registre (11) est reliée à une sortie de données de l'unité centrale (2), de façon à être commandée par cette dernière.

Par ailleurs, le registre (11) est relié à l'horloge (14) pilotant le dispositif.

Sur cette figure, on a également représenté le convertisseur (6) entre la source d'alimentation V_{cc} et les moyens (7) de blocage de la tension de programmation.

Le circuit (13) de réinitialisation automatique est par exemple constitué par un détecteur de tension associé à un générateur d'impulsions qui envoie un ordre de réinitialisation du registre (11) dès que la tension d'alimentation V_{cc} atteint la valeur minimale de fonctionnement correct des circuits logiques du dispositif. Après sa réinitialisation, la sortie du registre (11) délivre un signal de sorte que les moyens de blocage (7) interdisent l'application de la tension de programmation à la mémoire reprogrammable (5).

Pour que la sortie du registre (11) soit placée dans une configuration telle que les moyens de blocage (7) de la tension de programmation autorisent l'application de ladite tension à la mémoire reprogrammable (5), il faut que l'unité de traitement (2) charge le registre (11) dans une configuration telle que la sortie de ce registre soit dans un état opposé à celui dans lequel elle est positionnée lors de la réinitialisation. Pour cela, une sortie CVₚₚ de l'unité de traitement (2) est reliée à l'entrée de données du registre (11).

Ce dispositif est donc particulièrement performant puisque le registre (11) est placé dans une configuration correspondant à une autorisation de l'application de la tension de programmation, seulement sur requête de l'unité de traitement, lorsqu'il y a effectivement besoin d'effectuer un effacement ou une écriture. Ainsi, les moyens de blocage (7) sont activés tant qu'aucune écriture ou effacement n'est nécessaire, et la sécurité est considérable.

Dans un mode de réalisation, le registre (11) est constitué par une cellule élémentaire de mémorisation qui est préférentiellement mise dans un état déterminé lors de la réinitialisation. Il peut cependant arriver, dans des cas exceptionnels, qu'une telle cellule se positionne dans un état différent lors de la réinitialisation, ce qui, dans le cas d'espèce, conduirait à autoriser l'application de la tension de programmation. C'est pourquoi, comme illustré par cette figure 5, de préférence l'application des signaux de validation d'écriture WE ou d'effacement EE est également surbordonnée à l'état de registres (15, 16) qui sont initialisés à la mise sous tension dans un état correspondant respectivement à l'interdiction de l'application du signal de validation d'écriture et du signal de validation d'effacement. Sur cette figure 5, les sorties de ces deux derniers registres (15, 16) sont reliées respectivement aux entrées de validation d'écriture WE et d'effacement EE de la mémoire reprogrammable (5). Une telle liaison directe est effectuée dans le cas où les niveaux de sortie des dits registres sont compatibles avec les niveaux d'entrée nécessaires pour la validation de l'écriture ou de l'effacement dans la mémoire reprogrammable. Au cas où les niveaux ne sont pas compatibles, alors il est nécessaire de prévoir un convertisseur entre la sortie d'un registre et l'entrée correspondante de la mémoire reprogrammable. Lorsqu'une opération d'écriture ou d'effacement doit être effectuée, alors l'unité de traitement charge par sa sortie (CVₚₚ), en synchronisme avec l'horloge, le registre (11) de commande des moyens (7) de blocage dans un état autorisant l'application de la tension de programmation, et simultanément, elle charge le registre (15 et/ou 16) dans un état correspondant à l'autorisation de l'application du signal de validation d'écriture et/ou de validation d'effacement, selon l'opération requise. Des sorties (CWE, CEE) de l'unité de traitement (2) sont reliées à cet effet aux entrées de données des registres (15) et (16) respectivement.

Ce mode de réalisation est particulièrement avantageux car, il peut arriver que l'un des registres se positionne dans un état non souhaité lors de la réinitialisation, mais il est peu vraisemblable que la totalité des registres se positionne accidentellement dans une configuration non souhaitée.

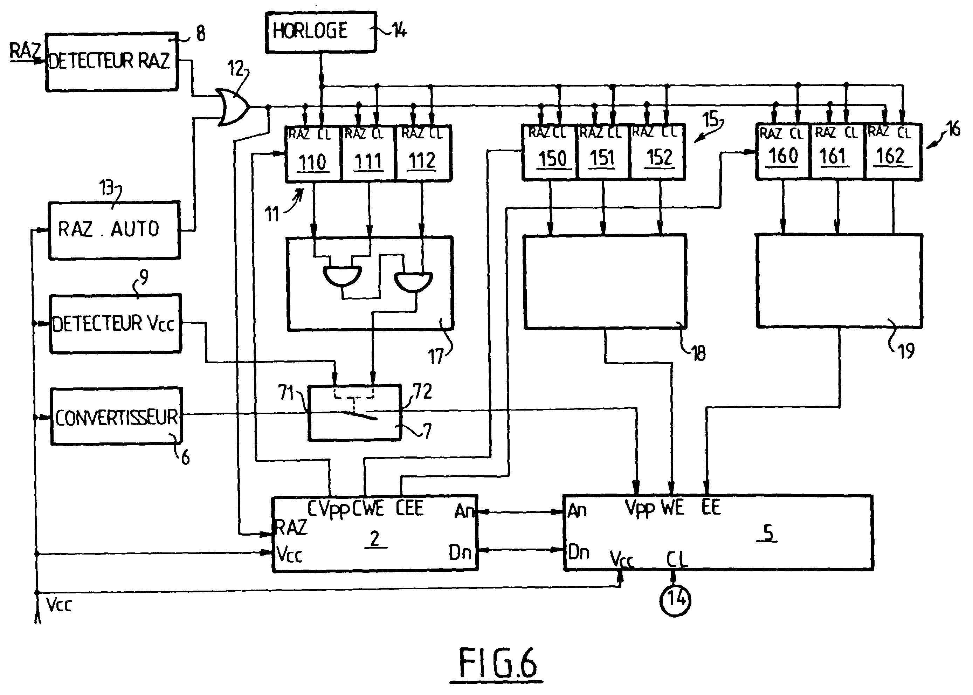

La figure 6 illustre une variante dans laquelle les registres (11, 15, 16) sont des registres à décalage, à entrée série et sorties parallèles, qui comprennent donc chacun un nombre non unitaire de bascules ou de cellules, dont les entrées de réinitialisation sont communes, et reliées au circuit combinatoire (12) identique à celui de la figure 5 recevant soit le signal de réinitialisation automatique, à la mise sous tension, soit un signal de demande de réinitialisation en cours de fonctionnement, et dont le chargement, qui s'effectue de façon séquentielle, est synchronisé par l'horloge (14) du dispositif, de sorte que l'unité de traitement doit exécuter une routine comportant plusieurs instructions pour charger chacun de ces registres. D'une façon similaire à la figure 5, l'unité de traitement comporte des sorties (CVₚₚ, CWE, CEE) reliées aux entrées de données des registres 11, 15, 16 respectivement, pour permettre le chargement des registres requis par l'opération souhaitée. Par ailleurs, une seule configuration de chargement de chacun de ces registres autorise l'application du signal qu'il commande, c'est-à-dire l'autorisation de l'application de la tension de programmation Vₚₚ pour le registre (11), l'autorisation de l'application du signal de validation d'écriture WE pour le registre (15), l'autorisation de l'application du signal de validation d'effacement EE pour le registre (16).

C'est pourquoi, dans le mode de réalisation illustré par cette figure 6, chaque registre est associé à un circuit combinatoire différent, un premier (17) pour le registre (11) d'autorisation de la tension de programmation, une seconde (18) pour le registre (15) d'autorisation d'application du signal de validation d'écriture, et un troisième (19) pour le registre (16) d'autorisation d'application du signal de validation d'effacement. Chaque circuit combinatoire contient autant d'entrées que le registre correspondant contient de bascules, de sorte que l'état de chacune des bascules d'un registre est répercuté à tout moment au circuit combinatoire correspondant. Par ailleurs, le circuit combinatoire correspondant à un registre porte une seule sortie qui est reliée à l'entrée correspondante de la mémoire reprogrammable qu'il commande. Cette liaison est directe si les signaux sont compatibles, ou s'effectue par l'intermédiaire de circuits adaptateurs ou convertisseurs si les signaux ne sont pas compatibles. Ainsi, dans l'exemple illustré, la sortie du circuit (17) associé au registre (11) est reliée à l'entrée de commande des moyens (7) de blocage de la tension de programmation Vₚₚ, alors que les sorties des circuits combinatoires (18 et 19) sont reliées directement respectivement aux entrées de validation d'écriture et de validation d'effacement de la mémoire reprogrammable (5).

Dans un mode de réalisation, les circuits combinatoires (17, 18, 19) utilisent en combinaison des fonctions logiques connues telles que les fonctions OU, OU EXCLUSIF, etc...

Le dispositif décrit sur la figure 6 fonctionne de la façon suivante : lorsqu'une écriture est requise, il faut positionner le registre (11) dans un état correspondant à l'autorisation de l'application de la tension de programmation Vₚₚ, et positionner simultanément le registre (15) dans un état correspondant à l'autorisation de l'application du signal de validation d'écriture WE, en exécutant des routines particulières de chargement de chacun de ces registres. De même, pour autoriser une opération d'effacement, il faudra charger le registre (11) d'autorisation d'application de la tension de programmation Vₚₚ, puis le registre (16) d'autorisation d'application du signal de validation d'effacement EE.

On comprend donc dans ce cas, que le dispositif est particulièrement fiable, car la multiplication du nombre des cellules nécessaires pour constituer chaque registre rend très peu probable le fait qu'une initialisation accidentelle les positionne dans un état correspondant à une autorisation de la commande correspondante.

Le mode de réalisation de la figure 6, avec trois registres différents, nécessite la sélection et le chargement approprié d'au moins deux registres lors d'une opération d'écriture ou d'effacement. Il faut systématiquement sélectionner le registre d'autorisation d'application de la tension de programmation, et le registre correspondant au signal de validation de l'opération choisie. Par ailleurs, selon que l'effacement de la mémoire non volatile sera total ou partiel, on pourra être amené à réaliser des combinaisons particulières de l'état de sortie de ces divers registres. Il en résulte que chacun de ces registres doit être relié à une sortie différente de l'unité de traitement, ou relié à la même sortie, et il faut des moyens de sélection de l'un et/ou de l'autre, pour charger les registres requis par une opération de programmation déterminée.

La figure 7 illustre une variante dans laquelle l'ensemble des registres est réuni de façon à former un registre à décalage unique (20) qui est relié à un circuit (21) combinatoire, comprenant autant d'entrées que le registre contient de bascules, et qui comporte une sortie (210) de commande de l'application de la tension de programmation Vₚₚ, une sortie (211) de commande du signal de validation d'écriture WE, et une sortie (212) de commande du signal de validation d'effacement EE. Cette structure permet de n'utiliser qu'un seul mode d'adressage lorsqu'une opération d'écriture ou d'effacement doit être effectuée, entraînant un chargement systématique du registre (20). Dans ce cas, le registre sera chargé avec des contenus différents selon qu'il s'agit d'une opération d'écriture ou d'effacement total ou partiel du contenu de la mémoire reprogrammable (5). A cet effet, une sortie de chargement (CC) de l'unité de traitement (2) est reliée à l'entrée série de données du registre (20).

Par ailleurs, la réinitialisation du registre (20) s'effectue de façon semblable à ce qui se produit dans le cas de la figure 6, c'est-à-dire qu'elle a lieu soit au moment de la mise sous tension par application d'un signal de réinitialisation automatique par le circuit (13) réagissant en fonction du niveau de la tension d'alimentation V_{cc}, soit sur un ordre de réinitialisation RAZ pendant le fonctionnement normal du dispositif, un circuit combinatoire (12) réalisant une fonction OU logique permettant de prendre en compte indifféremment l'un ou l'autre de ces ordres.

Pour la mise en oeuvre de ce dispositif, il est nécessaire de prévoir dans la mémoire de programme autant de routines que de possibilités d'interventions sur la mémoire reprogrammable (5) : il est nécessaire par exemple de prévoir une routine correspondant à un effacement complet de ladite mémoire, une routine correspondant à un effacement partiel, et une routine correspondant à une écriture de nouvelles données.

Par ailleurs, il est possible d'envisager plusieurs façons différentes de charger le registre à décalage de commande des effacements/écritures dans la mémoire reprogrammable.

Comme envisagé précédemment, la mémoire de programme peut contenir plusieurs routines complètes correspondant chacune à une opération spécifique (écriture, effacement total ou partiel) à effectuer sur la mémoire reprogrammable (5).

Les différentes variantes qui viennent d'être décrites offrent un degré de sécurité croissant lors de la réinitialisation du dispositif, pour éviter que les données contenues en mémoire non volatile reprogrammable (5) soient modifiées ou effacées. Le choix de l'une ou de l'autre des variantes est effectué en fonction de la compléxité du dispositif et/ou du niveau de sécurité requis.

Les diverses variantes qui viennent d'être décrites n'empêchent cependant pas que si l'unité de traitement, par accident, exécute des sauts d'adresses intempestifs, le programme s'exécute selon un séquencement non maîtrisé, ce qui peut, dans certains cas, entraîner des changements non souhaités dans la mémoire reprogrammable (5).

C'est pourquoi, dans un mode de mise en oeuvre, la mémoire (3) contenant le programme de fonctionnement de l'unité de traitement ne contient aucune routine complète permettant une écriture ou un effacement de la mémoire reprogrammable (5). Ainsi, lors d'un saut intempestif d'adresses, l'unité de traitement ne peut pas commander une opération de ce genre par erreur.

A cet effet, le programme est agencé pour pouvoir écrire dans la mémoire volatile (4) une routine d'écriture ou d'effacement de la mémoire reprogrammable (5) : ceci consiste à inscrire des instructions dans la mémoire volatile sous la forme de données.

Lorsque toutes les instructions sont écrites dans la mémoire volatile (4), le programme contenu dans la mémoire (3) se branche sur cette routine inscrite en mémoire volatile, et ladite routine s'exécute alors. A la fin de l'opération d'écriture ou d'effacement, le programme contenu dans la mémoire (3) reprend le contrôle des opérations en effaçant prioritairement la routine contenue dans la mémoire volatile (4). Ainsi, la routine ne peut plus s'exécuter.

Il est bien entendu que cette solution n'est envisageable que si la mémoire volatile (4) permet d'y exécuter du programme.

Cette solution est envisageable pour réaliser une routine de chargement du ou des registres à décalage qui ont été décrits en regard des figure 6 et 7, mais il est bien entendu qu'elle peut également s'appliquer au chargement d'une routine beaucoup plus simple dans la mémoire volatile qui commanderait l'application des ordres de programmation et d'effacement et/ou d'écriture, lors de la mise en oeuvre des variantes illustrées sur les figures 1 à 5.

L'invention est donc particulièrement facile à mettre en oeuvre sur tout type de dispositif de traitement de données, dans lequel la mémoire reprogrammable (5) peut être soit totalement, soit partiellement reprogrammée par l'unité de traitement (2), de même que l'on conçoit qu'elle puisse s'appliquer à des dispositifs monolithiques ou non. Ainsi, elle s'applique tout particulièrement aux microprocesseurs monolithiques autoprogrammables dont la tension de programmation Vₚₚ de la mémoire non volatile est délivrée à partir de la source de tension d'alimentation générale, et pour lesquels il est nécessaire de prévoir des sécurités à la mise sous et hors tension, de même que lors des phases de réinitialisation.

## Revendications

1. Dispositif de traitement de données, comportant une unité de traitement (2), une mémoire non volatile (5) effaçable et reprogrammable électriquement au moins sous le contrôle partiel de l'unité de traitement au moyen d'au moins un signal de programmation (Vpp, WE, EE), des moyens de détection (8, 8 bis, 12, 13) d'un signal de demande de réinitialisation du dispositif, et des moyens de blocage (7, 11, 15, 16, 20) agencés pour empêcher que ledit signal de programmation n'agisse sur la mémoire non volatile au moins tant que le signal de demande de réinitialisation possède un niveau propre à activer la réinitialisation, les moyens de blocage étant activés par les moyens de détection, caractérisé en ce qu'il comporte des moyens (13) tels qu'un détecteur à seuil pour émettre un signal de demande de réinitialisation à la mise sous tension du dispositif lorsque la valeur d'alimentation (Vcc) de ce dispositif a atteint une valeur minimale (Vcc min) pour laquelle les circuits logiques du dispositif fonctionnent correctement, ainsi que des moyens internes de demande de réinitialisation en cours de fonctionnement ; les moyens de blocage (7, 11, 15, 16, 20) sont connectés de façon à prendre en compte indifféremment l'un ou l'autre de ces signaux de demande de réinitialisation et comportent au moins un registre (11, 15, 16, 20) comprenant une entrée de réception desdits signaux de demande de réinitialisation, et une sortie reliée à des moyens de commande (21) d'au moins l'un des signaux (Vpp, WE, EE) nécessaires à la programmation de la mémoire reprogrammable (5), ce registre étant agencé pour qu'un ordre de réinitialisation le positionne dans une configuration correspondant à un blocage de la programmation, et possédant une configuration de programmation unique selon laquelle il doit être chargé pour autoriser une programmation, le chargement d'un registre s'effectuant par une sortie appropriée (CVpp, CWE, CEE) de l'unité de traitement, en synchronisme avec une horloge du dispositif.

2. Dispositif selon revendication 1, dans lequel ledit registre comprend une pluralité de cellules (110 à 112 ; 150 à 152 ; 160 à 162) fournissant des signaux d'activation respectifs à un circuit combinatoire (17 à 20), ledit circuit combinatoire étant agencé pour envoyer ledit signal de programmation à la mémoire non volatile seulement lorsqu'il reçoit des signaux d'activation correspondant à ladite configuration de programmation du registre.

3. Dispositif selon revendication 1 dans lequel le registre inclut un registre à décalage (20) ayant une entrée unique reliée à l'unité de traitement et autant de sorties que de signaux de programmation devant être transmis à la mémoire non volatile.

4. Dispositif selon revendication 1, dans lequel le signal de programmation comprend un signal d'alimentation (Vpp), un signal de commande d'écriture (WE), et un signal de commande d'effacement (EE).

5. Dispositif selon revendication 1, qui inclut une mémoire volatile (4), le chargement de ladite configuration de programmation dans le registre s'effectuant au moyen d'un programme de configuration comprenant des instructions exécutables situées dans la mémoire volatile.

6. Dispositif selon revendication 5, dans lequel lesdites instructions exécutables sont chargées en mémoire volatile par l'unité de traitement lorsque le dispositif reçoit un signal demandant la programmation de la mémoire non volatile.

7. Dispositif selon revendication 5, qui comprend des moyens pour effacer lesdites instructions chargées dans la mémoire volatile (4) dès que celles-ci ont été exécutées.

8. Dispositif de traitement de données selon l'une quelconque des revendications précédentes, caractérisé en ce que les moyens de détection comprennent des premiers moyens de détection (8, 8bis, 12, 13) agencés pour détecter un premier niveau (RAZ1) du signal de demande de réinitialisation et activer les moyens de blocage tant que le niveau de ce signal est compris entre ledit premier niveau et ledit niveau actif.

9. Dispositif de traitement de données selon la revendication 8, caractérisé en ce qu'une sortie (83) des premiers moyens de détection (8) est reliée à l'entrée de réinitialisation de l'unité de traitement (2) pour y appliquer un ordre de réinitialisation lorsque le signal de demande de réinitialisation a atteint ledit premier niveau.

10. Dispositif de traitement de données selon la revendication 8, caractérisé en ce qu'il comporte des seconds moyens de détection (10) d'un second niveau (RAZ2) du signal de demande de réinitialisation, dont la sortie est reliée à l'entrée de réinitialisation de l'unité de traitement (2), de façon à valider l'application d'un ordre de réinitialisation à l'unité de traitement (2), après que les premiers moyens de détection (8, 8bis) aient entrainé le blocage de l'application d'au moins un des signaux nécessaires à la programmation et de façon à invalider l'ordre de réinitialisation avant que le blocage soit autorisé par les premiers moyens de détection.

## Patentansprüche

1. Datenverarbeitungsvorrichtung, mit einer Verarbeitungseinheit (2), einem nichtflüchtigen speicher (5), der wenigstens unter der teilweisen Steuerung der Verarbeitungseinheit mittels wenigstens eines Programmiersignals (Vpp, WE, EE) elektrisch löschbar und umprogrammierbar ist, Mitteln zur Erfassung (8, 8bis, 12, 13) eines Anforderungssignals zur Reinitialisierung der Vorrichtunq sowie Sperrmitteln (7, 11, 15, 16, 20), die so beschaffen sind, daß sie wenigstens so lange, wie das Reinitialisierungs-Anforderungssignal einen für die Aktivierung der Reinitialisierung geeigneten Pegel besitzt, verhindern, daß das Programmiersignal auf den nichtflüchtigen speicher einwirkt, wobei die Sperrmittel durch die Erfassungsmittel aktiviert werden, dadurch gekennzeichnet, daß sie Mittel (13) wie etwa einen Schwellenwertdetektor, der beim Anlegen der Spannung an die Vorrichtung ein Reinitialisierungs-Anforderungssignal aussendet, wenn der Versorgungswert (Vcc) dieser Vorrichtung einen minimalen Wert (Vcc min) erreicht hat, bei dem die Logikschaltungen der Vorrichtung einwandfrei arbeiten, sowie interne Hittel für die Anforderung der Reinitialisierung im Lauf des Betriebs enthält; die Sperrmittel (7, 11, 15, 16, 20) in der Weise angeschlossen sind, daß sie unterschiedslos das eine oder das andere dieser Reinitialisierungs-Anforderungssignale berücksichtigen und wenigstens ein Register (11, 15, 16, 20) enthalten, das einen Eingang für den Empfang der Reinitialisierungs-Anforderungssignale und einen Ausgang besitzt, der mit Steuermitteln (21) für wenigstens eines der für die Programmierung des umprogrammierbaren Speichers (5) notwendigen Signale (Vpp, WE, EE) verbunden ist, wobei dieses Register so beschaffen ist, daß es durch einen Reinitialisierungsbefehl in eine Konfiguration versetzt wird, die einer Sperrung der Programmierung entspricht, und eine einzige Programmierkonfiguration besitzt, in der es geladen werden muß, damit es eine Programmierung zuläßt, wobei das Laden eines Registers durch ein geeignetes Ausgangssignal (CVpp, CWE, CEI) der Verarbeitungseinheit synchron mit einem Takt der Vorrichtung erfolgt.

2. Vorrichtung nach Anspruch 1, in der das Register mehrere Zellen (110 bis 112; 150 bis 152; 160 bis 162) enthält, die an eine kombinatorische schaltung (17 bis 20) entsprechende Aktivierungssignale liefern, wobei die kombinatorische Schaltung so beschaffen ist, daß sie das Programmiersignal zum nichtflüchtigen Speicher nur dann schickt, wenn sie Aktivierungssignale empfängt, die der Programmierkonfiguration des Registers entsprechen.

3. Vorrichtung nach Anspruch 1, in der das Register ein Schieberegister (20) enthält, das einen einzigen Eingang, der mit der Verarbeitungseinheit verbunden ist, und so viele Ausgänge besitzt, wie Programmiersignale zum nichtflüchtigen Speicher übertragen werden müssen.

4. Vorrichtung nach Anspruch 1, in der das Programmiersignal ein Versorgungssignal (Vpp), ein Schreibbefehlssignal (WE) sowie ein Löschbefehlssignal (EE) enthält.

5. Vorrichtung nach Anspruch 1, die einen flüchtigen Speicher (4) enthält, wobei das Laden der Programmierkonfiguration in das Register mittels eines Konfigurationsprogramms erfolgt, das die im flüchtigen Speicher befindlichen ausführbaren Befehle enthält.

6. Vorrichtung nach Anspruch 5, in der die ausführbaren Befehle durch die Verarbeitungseinheit in den flüchtigen Speicher geladen werden, wenn die Vorrichtung ein die Programmierung des nichtflüchtigen Speichers anforderndes Signal empfängt.

7. Vorrichtung nach Anspruch 5, die Mittel enthält, um die in den flüchtigen Speicher (4) geladenen Befehle zu löschen, sobald diese ausgeführt worden sind.

8. Datenverarbeitungsvorrichtung nach irgendeinem der Vorangehenden Ansprüche, dadurch gekennzeichnet, daß die Erfassungsmittel erste Erfassungsmittel (8, 8bis, 12, 13) enthalten, die so beschaffen sind, daß sie einen ersten Pegel (RAZ1) des Reinitialisierungs-Anforderungssignals erfassen und die Sperrmittel so lange aktivieren, wie der Pegel dieses Signals zwischen dem ersten Pegel und dem aktiven Pegel liegt.

9. Datenverarbeitungsvorrichtung nach Anspruch 8, dadurch gekennzeichnet, daß ein Ausgang (83) der ersten Erfassungsmittel (8) mit dem Reinitialisierungseingang der Verarbeitungseinheit (2) verbunden ist, um in diesen einen Reinitialisierungsbefehl einzugeben, wenn das Anforderungssignal den ersten Pegel erreicht hat.

10. Datenverarbeitungsvorrichtung nach Anspruch 8, dadurch gekennzeichnet, daß sie zweite Erfassungsmittel (10) für einen zweiten Pegel (RAZ2) des Reinitialisierungs-Anforderungsbefehls enthält, wovon der Ausgang mit dem Reinitialisierungseingang der Verarbeitungseinheit (2) verbunden ist, derart, daß die Eingabe eines Reinitialisierungsbefehle in die Verarbeitungseinheit (2) validiert wird, nachdem die ersten Erfassungsmittel (8, 8bis) die Sperrung der Eingabe wenigstens eines der für die Programmierung erforderlichen Signale bewirkt haben, und derart, daß der Reinitialisierungsbefehl ungültig gemacht wird, bevor die Aufhebung der Sperrung durch die ersten Mittel zugelassen wird.

## Claims

1. A data processing device, comprising a processing unit (2), a non-volatile, erasable and electrically reprogrammable memory (5) at least under the partial control of the processing unit by means of at least one programming signal (Vpp, WE, EE), means (8, 8bis, 12, 13) for detecting a signal requesting the reinitialisation of the device, and inhibiting means (7, 11, 15, 16, 20) arranged so as to prevent said programming signal from acting on the non-volatile memory at least while the reinitialisation request signal is at a level suitable for activating the reinitialisation, the inhibiting means being activated by the detection means, characterised in that it comprises means (13) such as a threshold detector for issuing a reinitialisation request signal upon the connection to voltage of the device when the supply value (Vcc) of this device has reached a minimum value (Vcc min) for which the logic circuits of the device function correctly, together with internal means for requesting reinitialisation during operation; the inhibiting means (7, 11, 15, 16, 20) are connected so as to take account impartially of one or other of these reinitialisation request signals and comprise at least one register (11,15,16, 20) comprising an input for receiving said reinitialisation signals, and an output connected to means (21) for commanding at least one of the signals (Vpp, WE, EE) necessary for programming the reprogrammable memory (5), this register being arranged so that a reinitialisation order positions it in a configuration corresponding to inhibiting of programming, and having a single programming configuration in accordance with which it has to be loaded in order to authorise programming, the loading of a register taking place via an appropriate output (CVpp, CWE, CEE) of the processing unit, in synchronism with a clock of the device.

2. A device according to Claim 1, in which said register comprises a plurality of cells (100 to 112; 150 to 152; 160 to 162) supplying activation signals in respect of a combinational circuit (17 to 20), said combinational circuit being arranged so as to send said programming signal to the non-volatile memory only when it receives activation signals corresponding to said programming configuration of the register.

3. A device according to Claim 1, in which the register includes a shift register (20) having a single input connected to the processing unit and as many outputs as there are programming signals that have to be transmitted to the non-volatile memory.

4. A device according to Claim 1, in which the programming signal comprises a supply signal (Vpp), a writing command signal (WE), and an erasing command signal (EE).

5. A device according to Claim 1, which includes a volatile memory (4), the loading of said programming configuration in the register taking place by means of a configuration program comprising executable instructions located in the volatile memory.

6. A device according to Claim 5, in which said executable instructions are loaded into volatile memory by the processing unit when the device receives a signal requesting the programming of the non-volatile memory.

7. A device according to Claim 5, which comprises means for erasing said instructions loaded in the volatile memory (4) as soon as they have been executed.

8. A data processing device according to any one of the preceding claims, characterised in that the detection means comprise first detection means (8, 8bis, 12, 13) arranged so as to detect a first level (RAZ1) of the reinitialisation request signal and to activate the inhibiting means as long as the level of this signal is comprised between said first level and said active level.

9. A data processing device according to Claim 8, characterised in that an output (83) of the first detection means (8) is connected to the reinitialisation input of the processing unit (2) so as to apply to it a reinitialisation order when the reinitialisation request signal has reached said first level.

10. A data processing device according to Claim 8, characterised in that it comprises second means (10) for detecting a second level (RAZ2) of the reinitialisation request signal, the output of which is connected to the reinitialisation input of the processing unit (2), so as to validate the application of a reinitialisation order to the processing unit (2), after the first detection means (8, 8bis) have led to the inhibition of the application of at least one of the signals necessary for programming, and so as to invalidate the reinitialisation order before inhibition is authorised by the first means.
